(19) **Europäisches Patentamt**

**European Patent Office**

**Office européen des brevets**

(11) Veröffentlichungsnummer: **0 327 656 B1**

(12) # EUROPÄISCHE PATENTSCHRIFT

(45) Veröffentlichungstag der Patentschrift: **12.08.92**

(21) Anmeldenummer: **88101969.9**

(22) Anmeldetag: **11.02.88**

(51) Int. Cl.⁵: **G01S 15/18**, G01S 15/04

(54) Ultraschall-Näherungsschalter.

(43) Veröffentlichungstag der Anmeldung:
**16.08.89 Patentblatt 89/33**

(45) Bekanntmachung des Hinweises auf die Patenterteilung:
**12.08.92 Patentblatt 92/33**

(84) Benannte Vertragsstaaten:
**CH DE FR GB LI**

(56) Entgegenhaltungen:
**DE-A- 2 344 702     GB-A- 1 139 272**
**US-A- 3 145 363     US-A- 3 555 499**
**US-A- 3 793 618     US-A- 4 326 273**
**US-A- 4 551 722**

(73) Patentinhaber: **Honeywell Regelsysteme GmbH**
**Kaiserleistrasse 55**
**W-6050 Offenbach am Main(DE)**

(72) Erfinder: **Lühr, Peter**
**Hainstrasse 54**
**W-6454 Bruchköbel(DE)**

(74) Vertreter: **Herzbach, Dieter et al**
**Honeywell Europe S.A. Holding KG Patent & License Dept. Kaiserleistrasse 55 Postfach 10 08 65**
**W-6050 Offenbach am Main(DE)**

**Beschreibung**

Die vorliegende Erfindung bezieht sich auf einen Ultraschall-Näherungsschalter, bei dem über zeitbestimmende Glieder ein Zeitfenster vorgegeben wird, innerhalb dessen nur Echoimpulse ausgewertet werden können. Ein derartiger Ultraschall-Näherungsschalter ist aus der GB-A 1 139 272 bekannt.

Ausgehend von diesem bekannten Ultraschall-Näherungsschalter ist es die Aufgabe der vorliegenden Erfindung, diesen so auszugestalten, daß er auch bei schwankendem Objektabstand eine sichere Detektion gestattet. Die Lösung dieser Aufgabe gelingt durch die Merkmale des Patentanspruches 1. Weitere vorteilhafte Ausgestaltungen des Näherungsschalters sind den abhängigen Ansprüchen entnehmbar.

Die Lösung dieser Aufgabe gelingt gemäß den kennzeichnenden Merkmalen des Patentanspruches 1. Weitere vorteilhafte Ausgestaltungen des US-Näherungsschalters gemäß der vorliegenden Erfindung sind den Unteransprüchen entnehmbar.

Anhand eines in den Figuren der beiliegenden Zeichnung dargestellten Ausführungsbeispieles sei im folgenden ein US-Näherungsschalter gemäß der Erfindung näher beschrieben. Es zeigen:

Fig. 1     ein Blockschaltbild des erfindungsgemäßen Näherungsschalters;

Fig. 2     den Takt- und Auswertemodul gemäß Fig. 1 in näheren Einzelheiten;

Fig. 3     den Sende- und Empfangsmodul gemäß Fig. 1 in näheren Einzelheiten; und

Fig. 4a,b,c   der Erläuterung der Funktion des erfindungsgemäßen Näherungsschalters dienende Signaldiagramme.

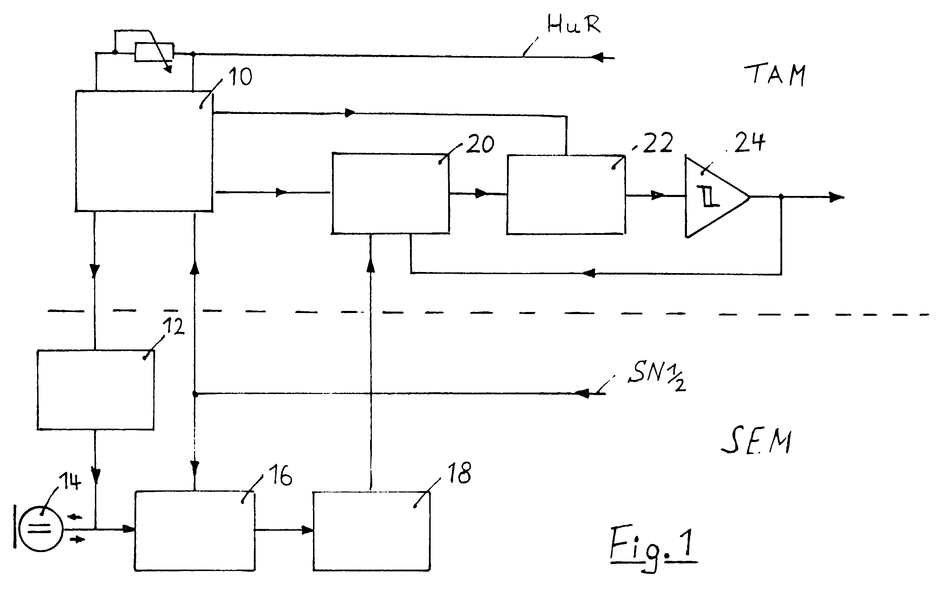

Gemäß Fig. 1 ist in der oberen, durch eine gestrichelte Linie getrennte Hälfte der Takt- und Auswertemodul TAM des Näherungsschalters und in der unteren Hälfte der Sende- und Empfangsmodul SAM dargestellt. Ein Arbeitstaktgenerator 10 beaufschlagt über einen Sender 12 einen US-Wandler 14. Das von dem US-Wandler 14 empfangene und an einem Objekt reflektierte US-Signal wird einem Empfänger 16 zugeführt und das verstärkte Empfangssignal beaufschlagt einen Demodulator- und Filterbaustein 18. Das herausgefilterte Empfangssignal wird über ein Zeitfenster 20 und ein weiteres Filter 22 einem Ausgangs-Schaltverstärker 24 zugeführt und steht an dessen Ausgang zur Weiterverarbeitung an.

Eine erste Steuerleitung HuR ist an den Taktgenerator 10 angeschlossen und dient dem Stopp des Sendebetriebs bzw. einer Meßbereichsveränderung. Eine zweite Steuerleitung SN1/2 ist sowohl an den Arbeitstaktgenerator 10 als auch an den Empfänger 16 angeschlossen und dient einmal der Beschleunigung der Meßfolge durch Erhöhung der Arbeitstaktgeschwindigkeit bei verringertem Objektabstand und zum anderen der Verminderung der Empfangsempfindlichkeit zwecks Verbesserung der Empfangs-Störsicherheit.

Sowohl das Filter 22 als auch das Zeitfenster 20 werden von dem Arbeitstaktgenerator 10 gesteuert. Ferner wirkt der Ausgangs-Schaltverstärker 24 auf das Zeitfenster 20 ein, um bei seinem Schalten eine bestimmte Schalthysterese vorzugeben.

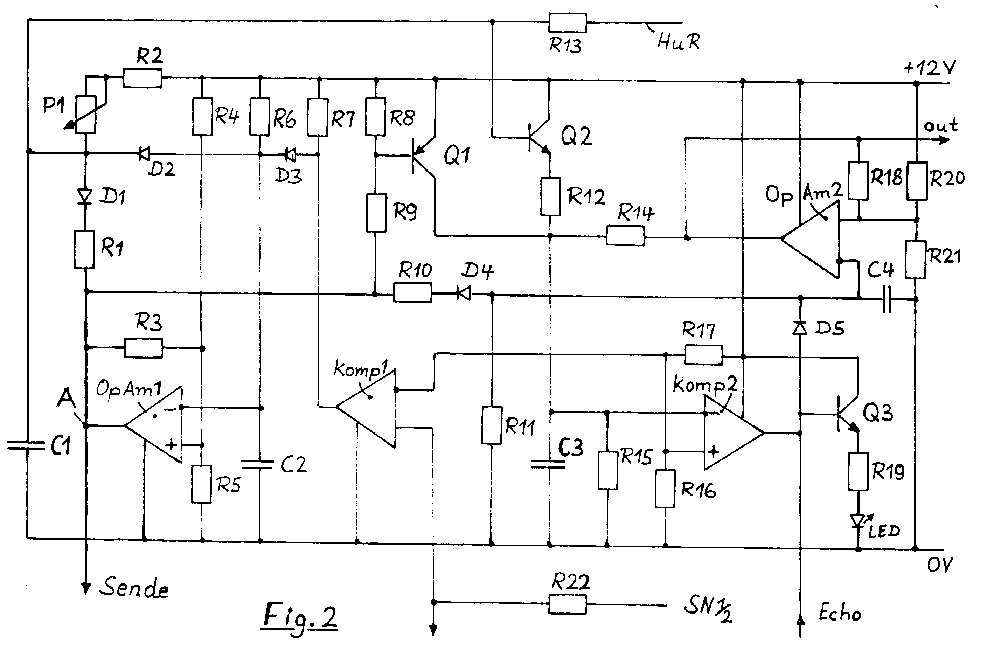

Fig. 2 zeigt in näheren Einzelheiten den Takt- und Auswertemodul TAM, dessen Aufbau und Funktion nachfolgend näher beschrieben werden soll.

Der Arbeitstaktgenerator umfaßt einen Operationsverstärker OpAm1, dessen positiver Eingang an einen zwischen die Betriebsspannung geschalteten Spannungsteiler R4, R5 angeschlossen ist und dessen Ausgang A über einen weiteren Widerstand R3 auf den positiven Eingang zurückgeführt ist. Der negative Eingang des Operationsverstärkers OpAm1 ist an den Abgriff eines zwischen die Betriebsspannung geschalteten RC-Gliedes angeschlossen, das einen Widerstand R6 und einen Kondensator C2 umfaßt. Beim Erreichen der durch die Widerstände R4, R5 vorgegebenen Referenzspannung auf dem Kondensator C2 schaltet der Operationsverstärker OpAm1 seinen Ausgang A auf Massepotential um, so daß sich der Kondensator C2 über eine Diode D2, eine weitere Diode D1 und einen Widerstand R1 in den Sender entlädt. Die Dimensionierung der Bauteile ist so getroffen, daß z.B. alle 9ms ein Taktimpuls von 50 µs erzeugt wird.

Der Arbeitstakt ist veränderbar, indem mit einem Signal auf einer Leitung SN1/2 über einen Widerstand R22 ein Komparator Komp1 geschaltet wird, wodurch ein zusätzlicher Ladepfad, bestehend aus einem Widerstand R7 und einer Diode D3, zu dem Kondensator C2 aktiviert wird. Hierdurch verkürzt sich die Taktperiode beispielsweise auf 3ms.

Das Zeitfenster wird durch einen entsprechend beschalteten Komparator Komp2 gebildet, dessen Ausgang an die Übertragungsleitung zwischen Empfänger und Schaltverstärker angeschlossen ist und der im betätigten Zustand diese Leitung auf Massepotential hält. Der positive Eingang des Komparators Komp2 ist an einen zwischen die Betriebsspannung geschalteten Spannungsteiler angeschlossen, der die Widerstände R16 und R17 umfaßt. Der negative Eingang des Komparators Komp2 ist an einen Kondensator C3 angeschlossen, dem ein Widerstand R15 zur Entladung parallelgeschaltet ist. Diese Parallelschaltung aus Kondensator C3 und Widerstand R15 ist an den Kollektor eines Transistors Q1 angeschlossen, dessen Emitter mit der positiven Betriebsspannung ( + 12V) verbunden ist. Die Basis des Transistors Q1 liegt an einem Spannungsteiler bestehend aus den Widerständen R8 und R9, die zwischen die positive Betriebsspannung und den Ausgang des Operationsverstärkers OpAm1 geschaltet sind. Wenn der Ausgang A dieses Operationsverstärkers OpAm1 bei seinem Umschalten auf Masse gelegt wird, so öffnet der Transistor Q1 und lädt schlagartig den Kondensator C3 mit der positiven Betriebsspannung. Hierdurch schaltet der Komparator Komp2, wodurch sein Ausgang auf Massepotential gelangt und das Zeitfenster geschlossen wird.

Nach Abgabe des Taktimpulses schaltet der Operationsverstärker OpAm1 an seinem Ausgang A wiederum um, und der Transistor Q1 wird geschlossen. Nunmehr entlädt sich der Kondensator C3 über den Widerstand R15. Hierdurch schaltet der Komparator Komp2 um, und das Zeitfenster wird geöffnet.

Vorgegeben durch die Aufladung eines Kondensators C1, der dem Kondensator C2 parallelgeschaltet ist und über die Diode D2 von diesem entkoppelt ist, wird ein weiterer Transistor Q2 betätigt, der als Spannungsfolger betrieben wird und über einen in seinem Emitterkreis angeordneten Widerstand R12 eine Aufladung des Kondensators C3 bewirkt. Die Aufladung des Kondensators C1 erfolgt über einen Widerstand R2 und ein einstellbares Potentiometer P1 aus der positiven Betriebsspannung. Außer über das Potentiometer P1 kann die Aufladung des Kondensators C1 auch von außen über eine Leitung HuR und einen Widerstand R13 beeinflußt werden. So kann beispielsweise durch Anlegen eines entsprechenden Potentials an diese Leitung der Sendebetrieb ganz gestoppt oder der Schließzeitpunkt des Fensters verändert werden. Im normalen Betrieb erreicht jedoch die Aufladung des Kondensators C3 über den Transistor Q2 und den Widerstand R12 zu irgendeinem Zeitpunkt einen Wert, bei dem der Komparator Komp2 schaltet und seinen Ausgang auf Massepotential legt, wodurch das Zeitfenster wiederum geschlossen wird.

Schließlich wird noch vom Ausgang des Ausgangs-Schaltverstärkers über einen Widerstand R14 die Aufladung des Kondensators C3 zwecks Erzeugung einer Schalthysterese verändert, d.h. der Schließzeitpunkt des Zeitfensters wird verschoben.

Ein Filter mit digitalen Eigenschaften wird durch einen Kondensator C4 vorgegeben, der durch innerhalb des Zeitfensters empfangene Echoimpulse stufenweise aufgeladen wird und andererseits bei jedem Arbeitstakt über eine Diode D4 und einen Widerstand R10 nach dem Ausgang A des Operationsverstärkers OpAm1 entladen wird. Die Dimensionierung ist hierbei so getroffen, daß erst bei mehreren empfangenen Echoimpulsen die Ladung ausreichend ist, um einen nachgeschalteten Schaltverstärker zu betätigen.

Eine Diode D5 verhindert hierbei eine Entladung zu dem Ausgang des Komparators Komp2. Eine lichtemittierende Diode LED zeigt den Empfang von Echoimpulsen an, indem diese bei nichtgeschaltetem Komparator Komp2 einen Transistor Q3 an der Basis ansteuern, der mit seiner Kollektor/Emitter-Strecke zu einem Widerstand R19 und der lichtemittierenden Diode LED in Reihe geschaltet ist, wobei die gesamte Reihenschaltung zwischen der Betriebsspannung betrieben wird.

Ein Schmitt-Trigger wird durch einen Operationsverstärker OpAm2 gebildet, dessen negativer Eingang an den Kondensator C4 angeschlossen ist und dessen positiver Eingang an einem Spannungsteiler, bestehend aus den Widerständen R20 und R21, liegt, die zwischen die Betriebsspannung geschaltet sind. Der Ausgang des Operationsverstärkers OpAm2 ist über einen Widerstand R18 auf den positiven Eingang zurückgeführt. Der auf diese Weise gebildete Schmitt-Trigger erzeugt ein Signal an seinem Ausgang, wenn die Ladung auf dem Kondensator C4 einen bestimmten vorgebbaren Wert erreicht. Hierzu sind normalerweise mehrere innerhalb eines Zeitfensters empfangene Echoimpulse erforderlich.

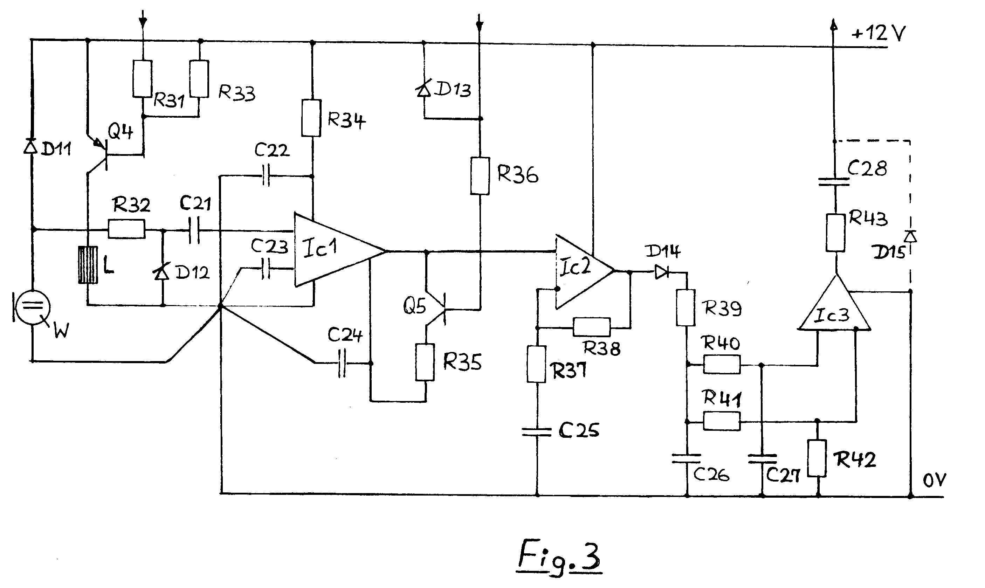

Der Sende- und Empfangsmodul SEM gemäß Fig. 3 weist einen im wesentlichen konventionellen Aufbau auf und soll nur insoweit näher beschrieben werden als er Besonderheiten beinhaltet.

Jeder Arbeitstakt schaltet über einen Transistor Q4 die volle Betriebsspannung an eine Spule L, so daß der entstehende Spannungsimpuls den Wandler W zu Schwingungen anregt. Eine Diode D11 ist hierbei als Freilaufdiode vorgesehen.

Ebenso regen empfangene US-Echoimpulse den Wandler zu Schwingungen an und die auf diese Weise entstehenden elektrischen Signale werden über einen Widerstand R32 und einen Koppelkondensator C21 einem ersten Verstärker IC1 zugeführt. Eine nach Masse geschaltete Zehnerdiode D12 dient der Begrenzung der Eingangsspannung des Verstärkers IC1. Eine Besonderheit stellt der umschaltbare Verstärkungsfaktor dieses Verstärkers dar. Wenn über die zweite Steuerleitung SN1/2 ein Signal angelegt wird, so wird nicht nur die Arbeitstaktfrequenz erhöht, sondern über den Widerstand R36 der Transistor Q5 angesteuert, wodurch entsprechend der Schaltabstandsverkürzung die Ansprechempfindlichkeit des Empfängers verringert wird. Ein nachgeschalteter Verstärker IC2 dient der nochmaligen Verstärkung.

Über eine Diode D14 wird die verstärkte Empfangsspannung gleichgerichtet und mit dieser gleichgerichteten Spannung wird über einen Widerstand R39 ein Kondensator C26 aufgeladen. Ein nachgeschalteter dynamischer Komparator umfaßt einen Verstärker IC3, dessen positiver Eingang an einem RC-Glied liegt, das aus einem hochohmigen Widerstand R40 und einem Kondensator C27 besteht. Der negative Eingang des Verstärkers IC3 ist an einen Spannungsteiler gelegt, der aus einem niederohmigen Widerstand R41 und einem hochohmigen Widerstand R42 besteht. Sowohl das RC-Glied (R40, C27) als auch der Spannungsteiler (R41, R42) sind dem Kondensator C26 parallelgeschaltet. Der Spannungsteiler R41, R42 gibt hierbei die Offset-Spannung vor. Die ganze Anordnung wirkt als Filter, das nur die Echos herausfiltert und als positive normierte Impulse an den Takt- und Auswertemodul liefert. Gleichstromkomponenten im Empfangssignal werden nicht ausgewertet und hochfrequente Rauschkomponenten werden unterdrückt.

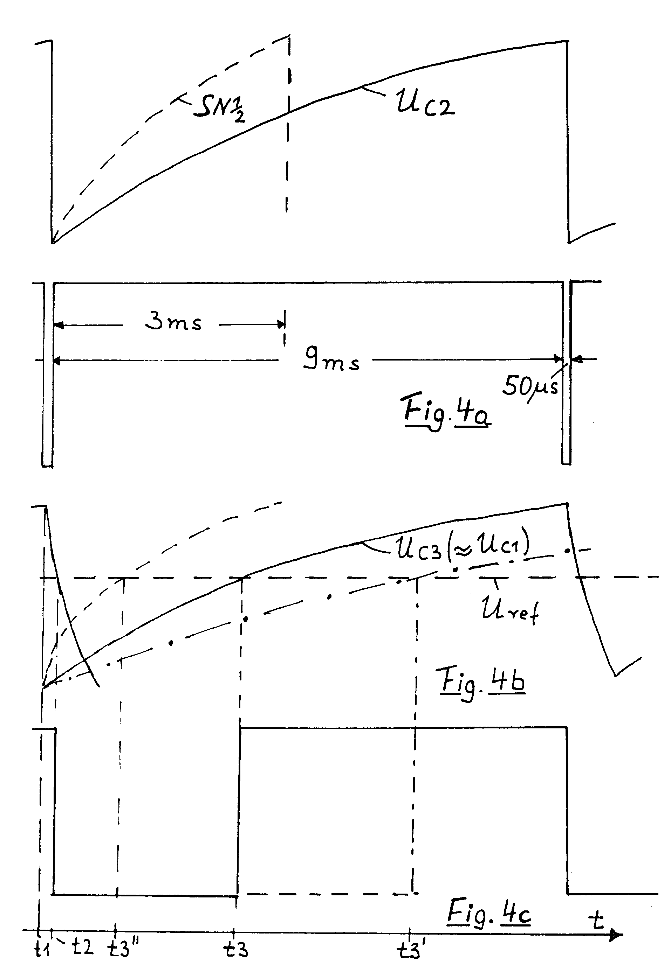

Anhand der Figuren 4a, b, und c sei im folgenden die Funktion des US-Näherungsschalters nochmals kurz erläutert.

Wenn der Operationsverstärker OpAm1 des Arbeitstaktgenerators schaltet, so werden die Kondensatoren C1 und C2 über den Widerstand R1 entladen. Dies führt zu der steil abfallenden Flanke gemäß Fig. 4a, wobei sich der Abfall über etwa $50\mu s$ erstreckt. In diesem Zeitpunkt t1 erfolgt die Anregung des Sendeimpulses. Mit dem Ausgang des Operationsverstärkers OpAm1 schaltet der Transistor Q1 um, wodurch der Kondensator C3 unmittelbar an Betriebsspannung gelegt wird. Da gemäß Fig. 4b die Ladespannung des Kondensators C3 den Pegel der Referenzspannung Uref übersteigt, ist im Zeitpunkt t1 gemäß Fig. 4c das Zeitfenster geschlossen.

Wenn der Operationsverstärker OpAm1 des Arbeitstaktgenerators wieder umschaltet, so wird auch der Transistor Q1 geschlossen, und der Kondensator C3 entlädt sich nunmehr über den Widerstand R15. Dies ist durch die exponentiell abfallende Flanke in Fig. 4b veranschaulicht. Im Zeitpunkt t2 unterschreitet die Spannung des Kondensators C3 den Referenzpegel des Komparators Komp2, so daß in diesem Zeitpunkt das Fenster geöffnet wird, was Fig. 4c entnehmbar ist. Gleichzeitig hat nach Entladung der Kondensatoren C1 und C2 im Zeitpunkt t1, deren erneute Aufladung begonnen. Durch die auf dem Kondensator C1 entstehende Ladung wird der Spannungsfolger Q2 geschaltet, so daß alle drei Kondensatoren C1, C2 und C3 eine exponentielle Aufladung erfahren, was in den Figuren 4a und 4b veranschaulicht ist, wobei die Spannung des Kondensators C3 in etwa der Spannung des Kondensators C1 entspricht. Im Zeitpunkt t3 erreicht die Spannung des Kondensators C3 den Referenzpegel des Komparators Komp2, so daß in diesem Zeitpunkt das Fenster geschlossen wird (Fig. 4c).

Über das Potentiometer P1 läßt sich die Aufladezeit des Kondensators C1 und somit auch die Aufladezeit des Kondensators C3 steuern, was zu einer Verschiebung des Schließzeitpunktes des Zeitfensters in den Zeitpunkt t3' führt. Dies ist in den Figuren 4b und 4c strichpunktiert dargestellt.

Bei Anlegung eines Signales über die Leitung SN1/2 ergeben sich die in den Figuren 4a, b und c dargestellten gestrichelten Verhältnisse, bei denen die Arbeitstaktperiode verringert wird und entsprechend dem verringerten Schaltabstand der Schließzeitpunkt des Fensters in den Zeitpunkt t3'' verlegt wird.

Die über den Ausgangs-Schaltverstärker OpAm2 und den Widerstand R14 vorgegebene Hysterese führt zu einer Verschiebung des Schließzeitpunktes t3 des Zeitfensters, was in Fig. 4c nicht berücksichtigt ist.

Bei dem vorstehend beschriebenen Ausführungsbeispiel kamen RC-Glieder zur Anwendung, um den Arbeitstakt und das Zeitfenster vorzugeben. In gleicher Weise könnten andere Zeitglieder, wie z.B. Zähler, verwendet werden, um die verschiedenen Schaltpunkte vorzugeben, ohne daß hierdurch ein digitales Zählverfahren zur Anwendung kommt. Wichtig für den vorliegenden US-Näherungsschalter ist die Registrierung von einem oder mehreren Impulsen innerhalb eines vorgebbaren Fensters, wobei die Laufzeit weder digital noch analog erfaßt wird. Es wird nur festgestellt, ob der Impuls innerhalb des Fensters liegt; wobei das Fenster einstellbar ist und zwecks Erzielung einer Hysterese beim Empfang eines oder mehrerer Impulse verbreitert wird.

## Patentansprüche

1. Ultraschall-Näherungsschalter mit einem Sender (12) und einem Arbeitstaktgenerator (10) für die Ansteuerung des Senders (12), wobei der Arbeitstakt des Senders durch ein erstes Zeitglied (R6,C2) des Arbeitstaktgenerators vorgegeben ist und mit einer an einen Empfänger (16) angeschlossenen Auswerteschaltung (18,20-24) für die Auswertung von Echosignalen, welche Auswerteschaltung aufweist:

A. ein von dem Empfänger (16) beaufschlagtes Filter (18);

B. einen Komparator (20;Komp.2,), der an das Filter (18) angeschlossenen ist, zur Vorgabe eines Zeitfensters für die Empfangssignale, wobei der Komparator (20;Komp2)

a) über einen ersten von dem Ausgang (A) des Arbeitstaktgenerators (10;OpAm1,R6,C2,R3,R4,R5) betätigten ersten Schalter (R8,R9,Q1) das Zeitfenster bei der Abgabe eines Arbeitstaktes schließt;

b) das Zeitfenster nach einer durch ein zweites Zeitglied (R15,C3) vorgegebenen Zeit öffnet; und

c) das Zeitfenster nach einer durch ein drittes Zeitglied (R12,C3) vorgegebenen Zeit wieder schließt; und

C. einen Schaltverstärker (24,OpAm2), wobei

d) dessen einer Eingang von der Aufladung eines Kondensators (22,C4) beaufschlagt ist und dieser Kondensator (22,C4) von den innerhalb des Zeitfensters liegenden Empfangssignalen aufgeladen wird und über einen an den Ausgang (A) des Arbeitstaktgenerators angeschlossenen Stromzweig (R10,D4) entladbar ist; und

e) dessen Ausgang über einen Widerstand (R14) an den Kondensator (C3) des zweiten und dritten Zeitgliedes (R12,R15,C3) angeschlossen ist, um dessen Aufladung zwecks Erzielung einer Schalthysterese zu verändern.

2. Näherungsschalter nach Anspruch 1, **dadurch gekennzeichnet,** daß der Schaltverstärker (24,OpAm2,R18-R21,C4) einen als Schmitt-Trigger geschalteten Operationsverstärker (OpAm2) umfaßt.

3. Näherungsschalter nach Anspruch 1, **dadurch gekennzeichnet,** daß das dritte Zeitglied (R12,C3) durch einen zweiten Schalter (Q2) betätigt wird, wobei der zweite Schalter (Q2) durch ein viertes Zeitglied (R2,P1,C1), dessen Zeit einstellbar ist, betätigt wird.

4. Näherungsschalter nach Anspruch 3, **dadurch gekennzeichnet,** daß die Zeitglieder durch RC-Glieder vorgegeben sind, daß das erste RC-Glied (R6,C2) dem vierten Zeitglied (R2,P1,C1) parallelgeschaltet ist, beide Zeitglieder über eine Diode (D2) voneinander entkoppelt sind und mit ihren Kondensatoren (C2,C1) an den Ausgang (A) des Arbeitstaktgenerators angeschlossen sind.

5. Näherungsschalter nach Anspruch 4, **dadurch gekennzeichnet,** daß das vierte Zeitglied (R2,P1,C1) über eine externe Leitung (HuR) in seinem Zeitverhalten steuerbar ist.

6. Näherungsschalter nach einem der Ansprüche 1 bis 5, **dadurch gekennzeichnet,** daß das erste Zeitglied (R6,C2) durch eine weitere externe Leitung (SN1/2), ein Schaltglied (Komp1) und einen zusätzlichen Strompfad (R7,D3) in seinem Zeitverhalten und damit der Arbeitstakt des Arbeitstaktgenerators veränderbar ist.

7. Näherungsschalter nach Anspruch 3, **dadurch gekennzeichnet,** daß beide Schalter durch Transistoren (Q1,Q2) vorgegeben sind und der zweite Transistor (Q2) als Spannungsfolger betrieben wird.

8. Näherungsschalter nach Anspruch 6, **dadurch gekennzeichnet,** daß die weitere externe Leitung (SN1/2) an ein weiteres Schaltglied (Q5) angeschlossen ist, das eine Umschaltung der Verstärkung des Empfängers (16) bewirkt.

**Claims**

1. Ultrasonic proximity switch comprising a transmitter (12) and a working clock generator (10) for driving the transmitter (12), whereat the working clock of the transmitter is provided by a first timing circuit (R6,C2) of the working clock generator, and an evaluation circuit (18,20-24) connected to a receiver (16) for the evaluation of echo signals, with said evaluation circuit comprising:

A. a filter (18) fed by the receiver (16);

B. a comparator (20; Komp. 2) connected to the filter (18) and providing a time window for the received signals, whereat the comparator (20; Komp. 2)

a) closes the time window at the delivery of a working clock via a first switch (R8,R9,Q1), which is actuated from the output (A) of the working clock generator (10; OpAm1,R6,C2,R3,R4,R5);

b) opens the time window after a predetermined time provided by a second time circuit (R15,C3); and

c) closes again the time window after a predetermined time provided by a third time circuit (R12,C3); and

C. a switching amplifier (24,OpAm2), whereat

d) the input of said amplifier is fed by the charge of a capacitor (22,C4), and said capacitor is charged by the received signals within said time window and is discharged by a current path (R10,D4) connected to the output (A) of said working clock generator; and

e) the output of said amplifier by means of a resistor (R14) is connected to the capacitor (C3) of the second and third time circuit (R12,R15,C3) in order to change its charge for achieving a switching hysteresis.

**2.** Proximity switch according to claim 1, **characterized in that** the switching amplifier (24,OpAm2, R18-R21,C4) comprises an operational amplifier (OpAm2) acting as a Schmitt-trigger.

**3.** Proximity switch according to claim 1, **characterized in that** the third time circuit (R12,C3) is actuated by a second switch (Q2), whereat the second switch (Q2) is actuated by a fourth time circuit (R2,P1,C1), the time of which is adustable.

**4.** Proximity switch according to claim 3, **characterized in that** the time circuits are provided by RC-circuits, that the first PC-circuit (R6,C2) is connected in parallel to the fourth time circuit (R2,P1,C1), that both time circuits are decoupled from each other by means of a diode (D2) and are connected with their capacitors (C2,C1) to the output (A) of the working clock generator.

**5.** Proximity switch according to claim 4, **characterized in that** the fourth time circuit (R2,P1,C1) is controllable with respect to its time behavior via an external line (HuR).

**6.** Proximity switch according to one of claims 1 to 5, **characterized in that** the first time circuit (R6,C2) with respect to its time behavior and therefore the working clock of the working clock generator is adjustable by means of a further external line (SN1/2), a switching component (Komp.1) and an additional current path (R7,D3).

**7.** Proximity switch according to claim 3, **characterized in that** both switches are implemented by transistors (Q1,Q2) and that the second transistor (Q2) is operated as a voltage follower.

**8.** Proximity switch according to claim 6, **characterized in that** the further external line (SN1/2) is connected to a further switching component (Q5) which effects a changing over of the gain of the receiver (16).

**Revendications**

**1.** Détecteur de proximité à ultrasons comportant un émetteur (12) et un générateur de cycles de travail (10) pour la commande de l'émetteur (12), le cycle de travail de l'émetteur étant prédéfini par un premier organe de temps (R6, C2) du générateur de cycles de travail, et comportant un circuit de traitement de données (18, 20-24) raccordé à un récepteur (16) et destiné au traitement de signaux d'écho, le circuit de traitement de données comprenant:

A. un filtre (18) alimenté par le récepteur (16);

B. un comparateur (20; Komp.2) qui est raccordé au filtre (18) pour prédéfinir une fenêtre de temps pour les signaux de réception, le comparateur (20; Komp.2)

a) fermant la fenêtre de temps lorsqu'un cycle de travail est délivré, par l'intermédiaire d'un premier commutateur (R8, R9, Q1) actionné par la sortie (A) du générateur de cycles de travail (10; OpAm1, R6, C2, R3, R4, R5);

b) ouvrant la fenêtre de temps après un temps prédéfini par un second organe de temps (R15, C3); et

c) fermant à nouveau la fenêtre de temps après un temps prédéfini par un troisième organe de temps (R12, C3); et

C. un amplificateur de commutation (24, OpAm2),

d) dont l'une des entrées est alimentée par la charge d'un condensateur (22, C4), ce condensateur (22, C4) étant chargé par les signaux de réception situés à l'intérieur de la fenêtre de temps, et pouvant être déchargé par une dérivation de courant (R10, D4) raccordée à la sortie (A) du générateur de cycles de travail; et

e) dont la sortie est raccordée, par l'intermédiaire d'une résistance (R14), au condensateur (C3) du second et du troisième organe de temps (R12, R15, C3), pour modifier la charge de celui-ci en vue d'obtenir une hystérésis de commutation.

**2.** Détecteur de proximité selon la revendication 1, caractérisé en ce que l'amplificateur de commutation (24, OpAm2, R18-R21, C4) comprend un amplificateur opérationnel (OpAm2) monté en tant que bascule de Schmitt.

**3.** Détecteur de proximité selon la revendication 1, caractérisé en ce que le troisième organe de temps (R12, C3) est actionné par un second commutateur (Q2), le second commutateur (Q2) étant actionné par un quatrième organe de temps (R2, P1, C1) dont la constante de temps est réglable.

**4.** Détecteur de proximité selon la revendication 3, caractérisé en ce que les organes de temps sont constitués par des circuits R-C, en ce que le premier circuit R-C (R6, C2) est monté en parallèle avec le quatrième organe de temps (R2, P1, C1), et en ce que les deux organes de temps sont découplés l'un de l'autre par l'intermédiaire d'une diode (D2) et sont raccordés par leurs condensateurs (C2, C1), à la sortie (A) du générateur de cycles de travail.

5. Détecteur de proximité selon la revendication 4, caractérisé en ce que le quatrième organe de temps (R2, P1, C1) peut être commandé quant à son comportement temporel, par l'intermédiaire d'une ligne extérieure (HuR).

6. Détecteur de proximité selon l'une des revendications 1 à 5, caractérisé en ce que le premier organe de temps (R6, C2) peut être modifié quant à son comportement temporel en provoquant ainsi la modification du cycle de travail du générateur de cycles de travail, par l'intermédiaire d'une autre ligne extérieure (SN1/2), d'un organe de commutation (Komp1) et d'un chemin de courant supplémentaire (R7, D3).

7. Détecteur de proximité selon la revendication 3, caractérisé en ce que les deux commutateurs sont constitués par des transistors (Q1, Q2), le second transistor (Q2) fonctionnant en suiveur de tension.

8. Détecteur de proximité selon la revendication 6, caractérisé en ce que l'autre ligne extérieure (SN1/2) est raccordée à un autre organe de commutation (Q5) qui produit une inversion de l'amplification de l'émetteur (16).

HuR

TAM

10

20 22 24

SN½

SEM

12

14 16 18

EP 0 327 656 B1

Fig.1

Fig.2

EP 0 327 656 B1

Fig.3

$SN\frac{1}{2}$   $U_{C2}$

3ms

9ms

50µs

Fig.4a

$U_{C3}(\approx U_{C1})$

$U_{ref}$

Fig.4b

Fig.4c   $t$

$t_1$  $t_2$  $t_3''$      $t_3$           $t_3'$